Europäisches Patentamt

European Patent Office

Office européen des brevets

(11) Publication number: **0 226 091**
**A2**

# (12) EUROPEAN PATENT APPLICATION

(21) Application number: **86116479.6**

(22) Date of filing: **27.11.86**

(51) Int. Cl.⁴: **H 01 L 21/76**
**H 01 L 21/306, H 01 L 21/316**

(30) Priority: **17.12.85 US 810001**

(43) Date of publication of application:
**24.06.87 Bulletin 87/26**

(84) Designated Contracting States:
**DE FR GB**

(71) Applicant: **TEXAS INSTRUMENTS INCORPORATED**
**13500 North Central Expressway**
**Dallas Texas 75265(US)**

(72) Inventor: **Zorinsky, Eldon J.**
**2217 Vickers Drive**
**Plano Texas 75075(US)**

(72) Inventor: **Keen, Ralph S.**
**7816 Sucess Road**
**Greensboro North Carolina(US)**

(74) Representative: **Leiser, Gottfried, Dipl.-Ing. et al,**
**Patentanwälte Prinz, Leiser, Bunke & Partner**
**Manzingerweg 7**
**D-8000 München 60(DE)**

(54) Semiconductor isolation using trenches and oxidation of anodized silicon sublayer.

(57) A method of fabricating an island of isolated semiconductor material is disclosed. An epitaxial layer (34) of heavily doped N⁻ material is uniformly grown on an N type silicon substrate (10), of thickness between about 0·5 and 5·0 microns. A lightly doped N⁻ epitaxial layer (14) is grown atop the first layer (34). Trenches (24, 26) are etched through the N⁻ epitaxial layer (14) into contact with the heavily doped N⁺ sublayer (34), or to the underlying substrate, depending upon the thickness of the first layer. The structure is anodized by bringing an anodizing solution (30) into contact with the heavily doped layer within the trenches, to convert the heavily doped N⁺ sublayer (34) into porous silicon. The porous silicon sublayer (34) is then oxidized and converted into an insulating silicon oxide sublayer. An N⁻ epitaxial island (28) is thereby formed, insulated vertically from the substrate (10) and laterally from other islands by the insulating sublayer (34).

Fig.4

EP 0 226 091 A2

*1*

TI-10399

## SEMICONDUCTOR ISOLATION USING TRENCHES AND OXIDATION OF ANODIZED SILICON SUBLAYER

### BACKGROUND OF THE INVENTION
### 1. FIELD OF THE INVENTION

This invention relates to improvements in semiconductor structures and methods for fabricating them. and more particularly to techniques for producing isolated semiconductor regions on a semiconductor substrate.

### 2. DESCRIPTION OF THE PRIOR ART

Many techniques for fabricating isolated semiconductor islands. tanks. or tubs in or on a semiconductor substrate are well known. Recent developments have focused on the anodization of heavily doped semiconductor sublayers to achieve electrical isolation beneath and surrounding the semiconductor islands. Examples of anodization isolation techniques are described in articles by R. P. Homstrom et al. "Complete Dielectric Isolation By Highly Selective and Self-Stopping Formation of Oxidized Porous Silicon." *Applied Physics Letters.* Vol. 42. No. 4. February 15. 1983: and by Kazuo Imai et al.. "Full Isolaiton Technology by Porous Oxidized Silicon and Its Application to LSIs". *IEDM.* page 376. 1981. Both describe techniques using ion implantation to form a heavily doped sublayer beneath the surface of the substrate and to form heavily doped walls extending between the surface of the substrate and the sublayer to define islands of undoped or lightly doped semiconductor material within the heavily doped regions. Subsequent anodization of the structure converts the heavily doped walls and sublayer into porous silicon. leaving islands and the silicon substrate unaffected by the anodization process. and not converted. After anodization. the substrate is exposed to an oxidizing environment. which transforms the porous walls and sublayer into a silicon oxide to provide the electrical insulation surrounding and separating the islands.

The ion implantation approaches have disadvantages. however. In implantation processes. an impurity concentration gradient is created across the sublayer. This reduces the control of the subsequent anodization process. and ultimately results in the formation of non-uniform pores in the sublayer. Moreover. because of energy considerations. the accuracy and uniformity of the implantation of a heavy concentration of ions deeply beneath the surface of the substrate is difficult to control. The oxidation of nonuniformly doped material results in variations in the oxide growth. and thus in the thickness of the sublayer This. in turn. may cause the substrate to warp. The implanted walls around each island. being the only access path to the sublayer. present a further limitation to the horizontal distance of the sublayer which can be anodized or oxidized. Consequently. the depth of the oxide isolation sublayer structures which can be achieved has been limited.

One technique to overcome the implanted sublayer problems is by forming the buried sublayer by first growing an epitaxial layer of heavily doped material onto the substrate and then growing an additional layer of a more lightly doped semiconductor material over

TI-10399

the heavily doped material. Because the buried layer is grown. rather than implanted. the dopant concentration can be carefully controlled so as to obtain any desired dopant concentration. and to eliminate an impurity gradient in the layer. This approach is described in co-pending U.S. Patent Applications serial numbers 666.698 and 666.942. both filed October 31. 1984. and assigned to the assignee of the present applications. and incorporated by reference as background.

It has nevertheless been found that the control of the current density in the anodization process is difficult to control. among other reasons. because of the relative structural sizes of the sidewalls and the sublayer. This results in difficulty in achieving a uniform pore size for subsequent oxidation. and ultimately in non-uniform regions surrounding the islands formed.

## SUMMARY OF THE INVENTION

In light of the above. and in accordance with the invention. an isolated semiconductor island structure and method of forming it is provided which substantially reduces or eliminates the shortcomings discussed above.

In accordance with a broad aspect of the invention. a method of forming an isolated semiconductor region is presented. The method begins in the manner of the technique of the aforementioned applications serial numbers 666.698 and 666.942 by growing a heavily doped N— epitaxial layer on an N type silicon substrate to become the isolating sublayer. and thereafter growing a lightly doped epitaxial top layer over it. Then a deep aperture or trench is formed by reactive ion etching through the lightly doped top layer. at least into the heavily doped sublayer. and. in some instances. into the substrate. to enable the sublayer to be directly exposed to anodization and oxidation environments. The structure is then placed into an electrolytic bath with a controlled current density and anodized for a time sufficient to anodize the heavily doped N— epitaxial sublayer to transform it into porous silicon having a uniform porosity. After the anodization step. the structure is placed into an oxidizing environment. and the porous sublayer is completely oxidized and converted into a silicon oxide.

At this point in the process. isolated islands of the lightly doped epitaxial top layer have been formed on a silicon oxide isolating layer. and circumscribed on their sides by the trench. In the preferred embodiment of the invention. the trench is then filled with a silicon oxide to isolate the lightly doped top layer islands. both on their sides and their bottoms.

## BRIEF DESCRIPTION OF THE DRAWINGS

For a more detailed description of the present invention. and for further features and advantages thereof. reference is now made to the following detailed description. taken in conjuction with the accompanying drawings. in which:

FIGURE 1 is a cross-section of a semiconductor substrate. with a heavily doped N— layer grown thereon:

*TI-10399*

FIGURE 2 is a cross-sectional view of the structure of FIGURE 1, and including an additional lightly-doped top epitaxial layer;

FIGURE 3 is a cross-sectional view showing trenches formed in accordance with the invention through the lightly doped top epitaxial layer and down partially into the heavily doped N+ sublayer:

FIGURE 4 is a cross-sectional view of the semiconductor structure depicting the formation of the porous sublayer formed by anodization of the N+ sublayer:

FIGURE 5 is a cross-sectional view of the semiconductor structure after the sublayer thereof has been oxidized and converted into silicon dioxide:

FIGURE 6 is a cross-sectional view of the masked semiconductor structure, with silicon dioxide deposited in the trenches; and

FIGURE 7 is a cross-sectional view of the semiconductor structure after a planarizing process.

In the various figures of the drawings. like reference numerals are used to denote like or similar parts. It will also be appreciated that in the drawings. various sizes and dimensions of the parts have been exaggerated or distorted for clarity of illustration and ease of description.

## DETAILED DESCRIPTION OF THE PREFERRED EMBODIMENTS

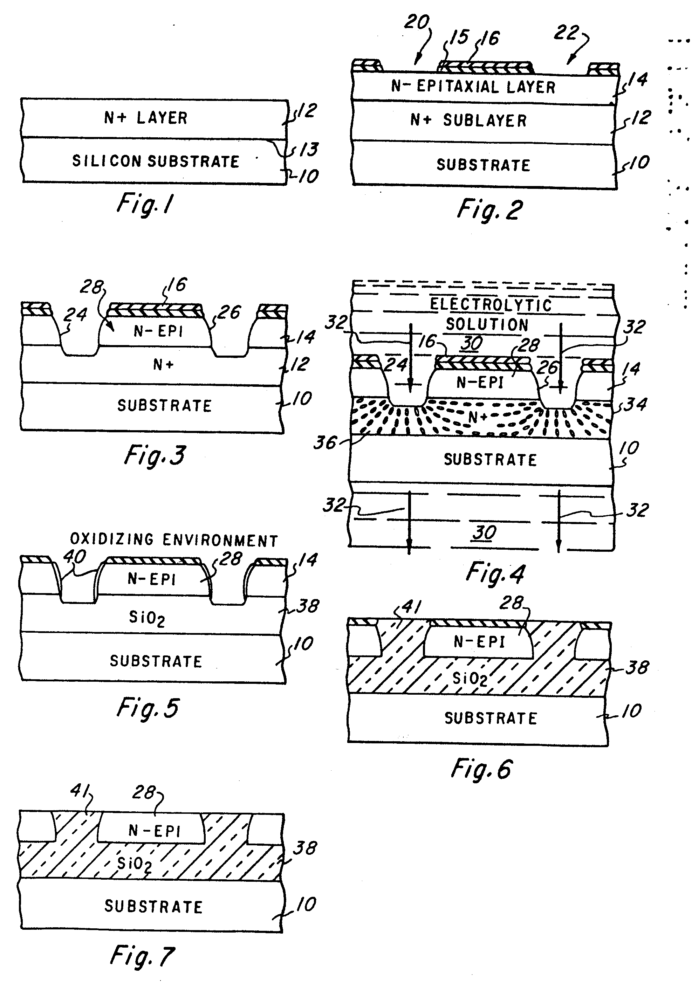

Referring now to FIGURE 1. there is illustrated a semiconductor substrate 10 on which the other layers of semiconductor material will be formed. The substrate 10 can be a (100 oriented monocrystalline substrate of N type silicon prepared according to conventional techniques. A heavily doped N+ first layer 12 is epitaxially grown on the substrate 10. The layer 12. which will subsequently be converted into an insulating oxide sublayer. can be doped. for instance. with arsenic. an N type impurity. with a concentration of in the range of approximately $1 \times 10^{18}$ to $1 \times 10^{19}$ atoms per cubic centimeter. The layer 12 can be grown to practically any desired depth. or thickness. to achieve. for example. a particular breakdown voltage. or to accomplish some other objective. as will be apparent to those skilled in the art. For example, the thicknesses of the layer 12 can be between 0.5 to 5 microns.

It will be appreciated that by epitaxially growing the 12 layer of heavily doped N – material. rather than by implantation or diffusion. virtually any desired thickness may be obtained without compromising the impurity concentration uniformity or doping gradient. Another advantage is that the epitaxy process produces a heavily doped layer which has a clearly defined boundary 13 between the layer 12 and the substrate 10.

Referring now to FIGURE 2. a second layer 14 is then formed on the N+ sublayer 12. Again, the top layer 14 is formed by a conventional epitaxial growth process. to a depth sufficient to enable various semiconductor devices, such as transistors, to be fabricated in it, as will be apparent to those skilled in the art. The top layer 14 is grown with arsenic. for instance, having a concentration. for example, less than $5 \times 10^{16}$ atoms per cubic

TI-10399

centimeter, to constitute a lightly doped N-layer. Thus. as the basis for the subsequent formation of active devices (not shown), the top layer 14 has a resistivity of about one ohm-centimeter. Further, the top layer 14 can be grown to a thickness of about .5 to three microns, as needed. However, in contrast to prior art techniques, the formation of the top layers 12 and 14 can be as thick as desired, without affecting the anodization and oxidation of the N+ sublayer 12. A mask, which can include multiple layers 15 and 16 (if desired) is formed over the N- epitaxial layer 14 to enable trenches, or apertures, described below to be formed in the structure. Masking structures and techniques are known in the art, and are not described in detail herein.

Referring now to FIGURE 3. trenches 24 and 26 are then etched through the top epitaxial layer 14 into the N- sublayer 12. Alternatively. apertures (not shown) can be formed with equal effectiveness in the top layer 14. extending through the sublayer 12. One technique to form the trenches 24 and 26. is to subject the exposed regions 20 and 22 to a Reactive Ion Etching (RIE) process. known in the art. which anisotropically removes the N- top layer 14 located directly below the unmasked regions 20 and 22. It has been found that the RIE process is preferred over wet etching techniques. as lateral erosion of the lightly doped top layer 14 does not occur. or can be controlled. Also. the RIE process does not exhibit the isotropic characteristics of wet etch processes. The RIE process is continued until the heavily doped N- sublayer 12 is encountered: or. as will be appreciated by those skilled in the art. depending upon the thickness of the layer 12. and depending upon the application and need for uniform porosity of the isolating layer to be formed. as discussed below, the etch can be continued until the substrate 10 is encountered. By carefully controlling the RIE process, the trenches 24 and 26 are formed with slightly angled or tapered sidewalls. as shown.

In order to provide sufficient dielectric isolation between semiconductor islands which will be formed of the material 28. the trenches 24 and 26 can be about two microns wide. The trenches can be made even narrower. if desired. to conserve semiconductor substrate space. and to accommodate a larger number of isolated islands. It is thus seen from FIGURE 3 that with the semiconductor structure trenched down into the heavily doped N- sublayer 12. the sidewall portions of the sublayer are exposed. Access to the heavily doped N- sublayer 12 facilitates the anodization process. discussed next.

Referring now to FIGURE 4. the semiconductor structure is shown immersed in an electrolytic solution 30. According to the invention. the trenches 24 and 26 allow the electrolytic solution 30 to directly contact the exposed sidewall portions of the N- sublayer 12. Anodization of the N+ sublayer 12 is thus facilitated. as the fresh electrolytic solution is immediately available at the sidewall portions of the N- sublayer 12. This is in contrast to prior art semiconductor anodization techniques in which the anodizing solution reaching the sublayer was first passed vertically through semiconductor material forming the sidewalls of the island. After having reacted with silicon material in the sidewalls

*TI-10399*

before reaching the sublayer. the anodizing solution was partially or completely depleted. causing the N− layer under the epitaxial islands 28 to become excessively porous. or even electropolished.

The electrolytic solution 30 comprises hydrofluoric acid and water. It has been found that an electrolytic solution of about 10% to 49%, by weight, hydrofluoric acid produces a suitable anodization of the heavily doped N+ sublayer 12.

To anodize the heavily doped N− sublayer 12, an electrical potential (not shown) is applied to the electrolytic solution 30. The potential applied to the solution 30 is controlled to keep the current density within the heavily doped region 12 substantially constant. A negative potential is applied to the electrolytic solution on the trenched side of the semiconductor structure. and a more positive potential is applied to the electrolytic solution 30 on the substrate 10 side of the structure. With the polarity of the anodization potential applied. current flows in the direction of the arrows 32.

According to known principles of semiconductor anodization. the heavily doped N− sublayer 12 is converted into porous silicon 34. of uniform porosity. but the lightly doped second layer 14 and the substrate 10 remain essentially unaffected. It will be appreciated by those skilled in the art that the pore size which results from the process described will be dependent upon the concentration of the electyrolytic solution used. the concentration of current and the doping levels of the material involved. any of which can be varied. depending upon the application or structure desired. It will be further appreciated that because of the proximity of the electrolytic solution 30 to the region underlying the region 26. as below discussed. the current density can be much more easily controlled during the anodization process to be constant, since the electrolytic solution is less likely to become depleted. and the area which is anodized can be designed to be of relatively constant cross-sectional area.

The anodization process is controlled so that about 45% to 55% of the N− sublayer 12 remains as N− silicon material. The remaining volume comprises pores 36 which are longitudinally aligned in accordance with the direction of the anodizing current flow. oriented generally in the direction shown in FIGURE 4. Because the resistivity of the heavily doped N− sublayer 12 is lower than that of either the lightly doped second layer 14 or the substrate 10. the current flow concentrates in the sublayer 12. Accordingly. the heavily doped N− sublayer 12 becomes completely anodized directly below the trenches. and horizontally along the sublayer 12. In contrast to the prior art. by virtue of the location and dimensions of the trenches 24 and 26. the cross-sectional area of the layer 12 which is anodized can be controlled. Thus. for example, as the anodization in the prior art proceeded from the sidewalls to the region underlying the N- layer 26, the cross-sectional area changed. causing a change in the current density. which was difficult to control. This difficulty was exacerbated by the depletion of the electrolyte solution. after having reacted with the sidewall material before "rounding the corner" to the underlying region. By providing the trenches 24 and 26. fresh electrolyte solution is brought into contact with the material for reaction. and the cross-sectional area is controlled, thereby enabling precise control of the current density during the anodization process.

With reference now to FIGURE 5, there is shown the semiconductor structure after the porous silicon 34 has been oxidized to form an insulating sublayer 38. To accomplish this structure, the porous silicon sublayer 34 is converted to an insulating layer of silicon dioxide 38 by exposing it to an oxidizing environment. such environments being known in the art. The porous silicon sublayer 34 oxidizes at a substantially higher rate than the nonporous N- epitaxial island 28. because of the higher surface area of the porous silicon. The top surface of the epitaxial island 28 is protected. where desired, from oxidation by the nitride of the masking layer 16. During this oxidizing process. the N- porous silicon 34 is consumed and expands volumetrically into the pores 36 previously described with respect to FIGURE 4. Because the anodization process removed about 45% to 55% of the N- silicon in the sublayer 12. the remaining N+ silicon is consumed during oxidation and completely fills the sublayer space with silicon dioxide 38.

Also. during the oxidizing of the sublayer 12. oxide deposits 40 form on the trench sidewalls of the N- epi second layer 14. The lateral growth of these silicon oxide deposits 40 grows wider near the opening of the trenches 24 and 26. because the rate of expansion of the bulk silicon is less than the porous silicon. Accordingly. since the trench sidewalls were tapered outwardly toward the top of the trenches 24 and 26. as described above. the overgrowth of silicon oxide thereat results in substantially a vertical walled trench. Because silicon dioxide exhibits a very high resistance to electrical currents. the sublayer 38 provides an excellent isolation between the lightly doped epitaxial island 28 and the substrate 10.

As shown in FIGURE 6. the isolation of the N- epitaxial island 28 is completed by filling the trenches 24 and 26 with a dielectric isolating material preferably silicon dioxide 41. The trench oxide 41 merges with the sidewall oxide 40 (FIGURE 5) to form a homogeneous isolation surrounding the island 28. Alternatively. an oxide reflow technique can be utilized to fill the trenches 24 and 26 with a dielectric isolating material. In an oxide reflow technique a phosphorus or a boron-phosphorus doped layer of silicon oxide can be deposited on the semiconductor structure by a low pressure chemical vapor deposition. The phosphorus layer conformably coats the structure. Then. the semiconductor structure can be heated to a temperature of 900°C to 1000°C until the doped oxide becomes viscous and flows to fill the trench voids. It will be appreciated that the trenches 24 and 26 could easily be filled with other dielectric isolating materials by other well-known techniques: for example. as will be appreciated by those skilled in the art. the trenches 24 and 26 can be filled with a polysilicon material to provide lateral isolation between N- epitaxial islands 28.

Conformal refill of the trenches 24 and 26 may result in an irregular top surface (not

TI-10399

shown). If planarization is required in order to provide a suitably flat surface for subsequent masking or metallization patterning, conventional planarization techniques can be employed, such as by using a photoresist with an etch rate comparable to the etch rate of the trench oxide 41, and etching both materials downwardly until the oxide level is even with the top of the N- epitaxial island 28, as shown in FIGURE 7.

Thus, the resulting structure shown in FIGURE 7, according to the invention, has a uniform silicon dioxide sublayer 38, and oxide-filled sidewall areas 41 laterally surrounding the epitaxial island 28. Because the sublayer 38 was initially a uniformly doped epitaxial layer, the corresponding growth of silicon dioxide is also uniform in depth and density. This prevents warpage or damage to the overlaying layers and substrate due to uneven formation and expansion of the silicon oxide in the sublayer, in contrast to the anodization and oxidizing techniques of the prior art.

Thus, in accordance with the invention, with the use of an epitaxial growth of semiconductor material for the sublayer on the substrate, a uniformly doped sublayer of virtually any desired thickness can be formed. Moreover, regardless of the depth of the top N- layer, apertures or trenches can be formed to the heavily doped sublayer to facilitate its anodization horizontally to lengths heretofore unobtainable.

Although the preferred embodiment of the invention has been described in detail, it should be understood that various changes, substitutions and alterations can be made therein, such as for example, the conditioning of the porous layer to optimize subsequent isolation oxidation thereof. Such changes can thus be made by those skilled in the art without departing from the spirit and scope of the invention as defined by the appended claims.

TI-10399

## WHAT IS CLAIMED IS:

1. A method of fabricating an isolated semiconductor island on a substrate, comprising the steps of:

forming a first doped epitaxial layer of semiconductor material on said substrate:

forming a second epitaxial layer of semiconductor material on said first layer, the dopant concentration of said second layer being less than the dopant concentration of said first layer:

forming an aperture through said second layer surrounding a portion of said second layer and extending to said first layer:

anodizing said first layer by exposing it to an anodizing solution in said aperature to transform said first layer into a porous semiconductor material: and

exposing said porous semiconductor material to an oxidizing environment to convert said porous semiconductor material into an insulating material.

2. The method of claim 1 further including filling said aperture with an insulating material.

3. The method of claim 2 wherein said aperture is filled with a material comprising a silicon oxide.

4. The method of claim 1 wherein said step of forming said first epitaxial layer comprises growing a heavily doped layer.

5. The method of claim 4 wherein said first doped layer if grown to a thickness of between about 0.5 to 5 microns thick.

6. The method of claim 1 wherein said step of forming said second epitaxial layer is formed by growing an epitaxial layer of semiconductor material on said first layer having a doping concentration between approximately $5 \times 10^{18}$ to $1 \times 10^{19}$ atoms per cubic centimeter.

7. The method of claim 8 wherein said second doped layer is grown to a depth of about four microns.

8. A method of fabricating an isolaed semiconductor island in an N type silicon substrate, comprising the steps of:

epitaxially growing a first layer of uniformly doped silicon on said substrate, said first layer having an N type impurity concentration sufficient for conversion thereof into a porous material through anodization:

epitaxially growing a second silicon layer on said first layer, said second layer having an N type impurity concentration less than sufficient for conversion into a porous material through anodization:

forming a trench through said second layer and to said first layer, said trench forming an island of second layer:

directly dontacting said first layer to an anodization solution in said trench to anodize said first layer to form porous silicon of uniform porosity of said first layer material:

oxidizing said porous silicon of said first layer to transform said porous silicon into a

TI-10399

silicon oxide to electrically insulate said island from said substrate; and

filling said trench with an insulating material.

9. The method of claim 8 wherein said step of filling said trench with an insulating material comprises filling said trench with a silicon oxide.

10. The method of claim 9 wherein said first layer is formed with a thickness of between about 0.5 and 5.0 microns.

0226091

Fig. 1

Fig. 2

Fig. 3

Fig. 4

Fig. 5

Fig. 6

Fig. 7